# FASCICULE DE BREVET EUROPEEN

(11) **EP 0 752 723 B1**
(45) Date de publication et mention de la délivrance du brevet: **07.05.2003**
(21) Numéro de dépôt: 96401456.7
(22) Date de dépôt: 02.07.1996
(51) Int. Cl.: H01L 29/737

(54) **Transistor bipolaire à structure optimisée**
Bipolartransistor mit optimierter Struktur
Bipolar transistor with optimized structure

(30) Priorité: 07.07.1995 FR 9508238
(43) Date de publication de la demande: 08.01.1997
(73) Titulaire: Thales, 75008 Paris (FR)
(72) Inventeur: Delage, Sylvain, 92402 Courbevoie Cedex (FR); Poisson, Marie-Antoinette, 92402 Courbevoie Cedex (FR); Brylinski, Christian, 92402 Courbevoie Cedex (FR); Blanck, Hervé, 92402 Courbevoie Cedex (FR)

(56) Documents cités:
- EP-A- 0 194 197
- EP-A- 0 630 053
- US-A- 5 298 439
- APPLIED PHYSICS LETTERS, vol. 62, no. 9, 1 Mars 1993, NEW YORK US, pages 994-996, XP000345863 G.B. GAO ET AL.: "AlxGa1-xAs/AlyGa1-yAs and GaAs pseudo-heterojunction bipolar transistors with lateral emitter resistor"
- PATENT ABSTRACTS OF JAPAN vol. 18, no. 617 (E-1634), 24 Novembre 1994 & JP-A-06 236892 (NIPPON TELEGR & TELEPH CORP), 23 Août 1994,
- ELECTRONICS LETTERS, vol. 30, no. 25, 8 Décembre 1994, STEVENAGE GB, pages 2174-2175, XP000502119 H. ITO ET AL.: "Compositionally graded emtter InGa(As)P/GaAs heterojunction bipolar transistors"

## Description

Le domaine de l'invention est celui des transistors bipolaires et notamment de transistors bipolaires à hétérojonction, à structure verticale, dans lesquels le courant est transporté perpendiculairement à la surface du substrat, utilisés pour des applications hyperfréquences.

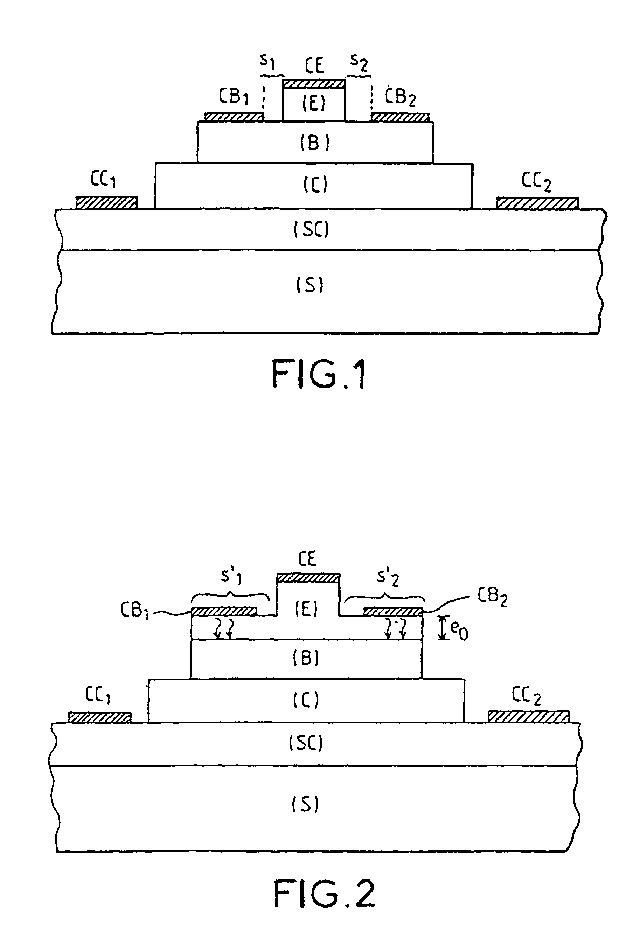

Ils sont constitués d'un empilement de couches de matériaux semiconducteurs, dont au moins une couche superficielle est gravée en "mésa", c'est-à-dire dire forme un motif en relief. La figure 1 décrit la structure classique d'un transistor bipolaire à hétérojonction dits HBT, dont l'émetteur, la base et le collecteur sont sur trois niveaux différents. Classiquement un contact C_{E} est réalisé à la surface de l'émetteur par superposition de couches adaptées. Latéralement deux contacts C_{B1} et C_{B2} sont réalisés au niveau de la base de part et d'autre de l'émetteur et deux contacts C_{C1} et C_{C2} sont également réalisés au niveau du collecteur de part et d'autre de la base.

Ce type de structure verticale pose un problème de recombinaisons électrons/trous, au niveau des surfaces libres s₁ et s₂ illustrées en figure 1, ces recombinaisons jouant un rôle majeur dans la dégradation de gain en courant.

Ce phénomène étant d'autant plus important que les transistors sont de petites tailles (fuite des électrons sur les bords), les applications en hyperfréquences de telles structures verticales sont fortement pénalisées par ce problème. En effet, pour un fonctionnement en hyperfréquence, un transistor bipolaire consiste en plusieurs transistors élémentaires (encore appelés doigts) mis en parallèle et afin de limiter la résistance de base d'un transistor élémentaire, il est nécessaire de limiter la largeur de l'émetteur. Typiquement, la largeur d'un doigt peut être de l'ordre de 2 µm pour des applications à des fréquences inférieures à 100 GHz, alors que la longueur du doigt d'émetteur peut être d'une trentaine de microns.

Certaines solutions ont déjà été apportées à ce problème et notamment dans le cadre de transistors HBT élaborés avec des matériaux GaAIAs/GaAs. Notamment, il a été envisagé d'introduire une couche de passivation entre émetteur et base, créant une zone dépeuplée, intermédiaire dans laquelle les recombinaisons électrons/trous sont rendues pratiquement impossibles en raison de la disparition des porteurs libres dans cette zone. Plus précisément, la figure 2 décrit une structure dans laquelle l'émetteur possède une architecture particulière obtenue par gravure partielle d'une couche de GaAIAs déposée sur une couche de GaAs dopée p, constituant la base. Deux contacts C_{B1} et C_{B2} sont réalisés au niveau de la couche émettrice sur des surfaces s'₁ et s'₂ puis par un traitement adaptée, ces contacts peuvent diffuser sur l'épaisseur eₒ. Dans cette configuration, les recombinaisons électrons/trous dans la base, favorisées antérieurement au niveau de la surface libre de la base, sont limitées en raison de l'épaisseur eₒ d'émetteur, maintenue au-dessus de la base. Le problème de ce type de structure réside cependant dans leur mauvaise stabilité dans la mesure où la diffusion réalisée pour les contacts ne peut être entièrement maîtrisée et peut donc ainsi continuer à évoluer avec le temps et la température.

C'est pourquoi l'invention propose une structure optimisée de transistor bipolaire à hétérojonction dans laquelle les recombinaisons de surface sont minimisées grâce à une architecture particulière d'émetteur.

Plus précisément l'invention a pour objet un transistor bipolaire à hétérojonction à base de matériaux semiconducteurs du groupe III-V comprenant un substrat sur lequel sont respectivement superposés un collecteur, une base et un émetteur, caractérisé en ce que l'émetteur possède une structure dite de "double mésa" comprenant au moins trois couches (1), (2) et (3) de matériaux semiconducteurs M_{I}, M_{II}, M_{III}, superposés à partir de la base, les couches (1) et (2) présentant une section plus grande que la section de la couche (3), les sections des couches étant définies parallèlement au substrat, la couche (1) étant faiblement dopée pour assurer la fonction de passivation.

De préférence, les couches (1) et (3) sont constituées à partir du même matériau semiconducteur M_{I} ; les matériaux M_{I} et M_{II} possédant des comportements différents vis-à-vis d'un couple de procédés de gravure.

Dans le transistor bipolaire selon l'invention, le matériau M_{I} est de préférence du GalnP, le matériau M_{II} étant de préférence du GaAs.

Le transistor bipolaire à hétérojonction peut de plus avantageusement comprendre une couche (4) intégrée, entre l'émetteur proprement dit et des couches d'accès au contact C_{E}. Cette couche peut typiquement être élaborée à partir de matériau (III) dopé plus faiblement que dans la couche (3) pour constituer une résistance de ballast intégrée au niveau de l'émetteur.

La présence de cette couche (4) peut s'avérer particulièrement intéressante dans des applications de puissance utilisant notamment des transistors bipolaires à hétérojonction montés en parallèle, applications pour lesquelles le phénomène d'emballement thermique est crucial.

En effet, le mécanisme fondamental de l'emballement thermique, provient du décalage d'environ - 1,5 mV/K de la caractéristique I_{E} (V_{BE}) (courant d'émetteur en fonction de la tension appliquée entre l'émetteur et la base). Cela entraîne qu'une fraction du composant élémentaire draine la majorité du courant émetteur. Si l'on fixe, par exemple le courant de la base, plus le composant s'échauffe et plus le courant se concentre dans les zones les plus chaudes de plus en plus localisées. Ce mécanisme induit finalement la formation d'un point chaud qui entraîne la destruction du dispositif.

L'utilisation d'une résistance intégrée par rapport à la solution classique qui consiste à rapporter une résistance extérieure sur l'émetteur, permet de diminuer d'une trentaine de pourcent (évalué expérimentalement) la valeur de la résistance nécessaire pour pallier l'emballement thermique, ce qui conduit par conséquent à un niveau de performances nettement supérieur.

L'invention sera mieux comprise et d'autres avantages apparaîtront à la lecture de la description qui va suivre donnée à titre non limitatif et grâce aux figures annexées parmi lesquelles :
- la figure 1 illustre une structure classique de transistor bipolaire ;
- la figure 2 illustre une architecture de transistor bipolaire selon l'art antérieur ;
- la figure 3 illustre la structure de transistor bipolaire selon l'invention ;
- la figure 4 illustre un exemple de structure épitaxiale, utilisée dans un transistor bipolaire à hétérojonction, selon l'invention ;
- la figure 5 illustre une vue générale en coupe d'un exemple de transistor bipolaire selon l'invention.

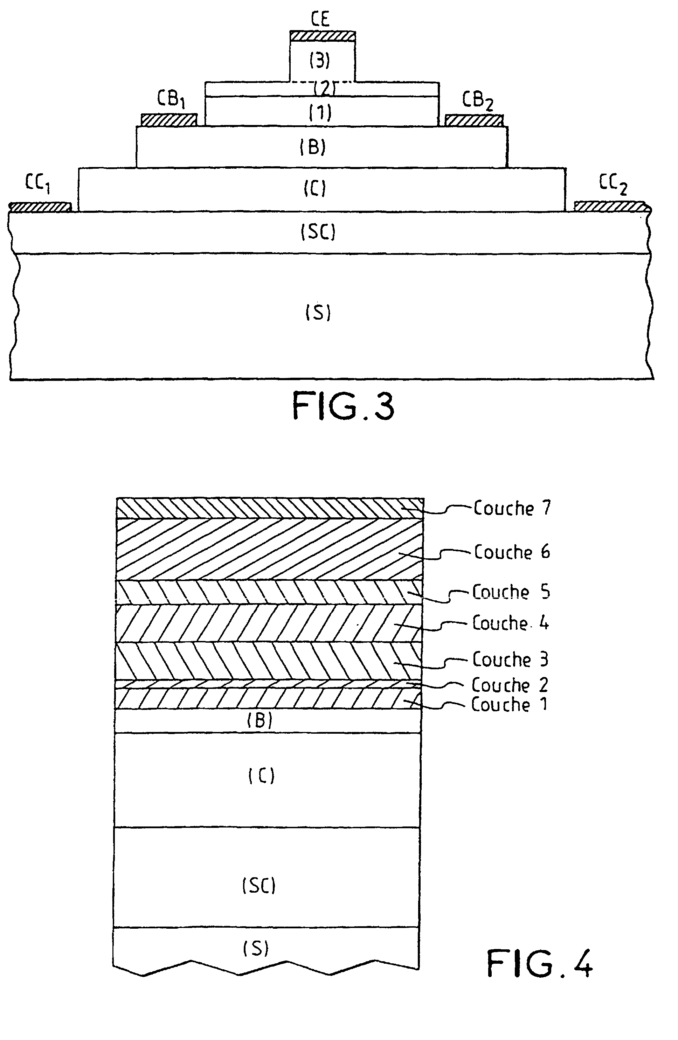

L'invention propose une nouvelle architecture de transistor bipolaire et notamment de transistor bipolaire à hétérojonction dans laquelle l'émetteur possède une structure originale. La figure 3 illustre cette structure composée d'au moins trois couches (1), (2) et (3) superposées à la base B, elle-même superposée au collecteur C. En utilisant des matériaux M_{I} et M_{III} tels qu'on maîtrise très bien leur gravure sur respectivement la base B et la couche (2) on est en mesure de réaliser l'architecture en double "mésa" de l'émetteur sur la base. Ceci permet ainsi d'élaborer les contacts de base C_{B1} et C_{B2}, sans avoir recours à des processus de diffusion dans le milieu émetteur comme cela avait été proposé dans l'art antérieur.

Nous allons décrire l'invention dans le cas précis d'un transistor bipolaire à hétérojonction élaboré à partir de matériaux semiconducteurs GalnP et GaAs. En effet, ce couple est particulièrement intéressant par rapport au système plus conventionnel GaAl/As/GaAs pour plusieurs raisons.

Par ailleurs, il existe divers procédés de gravure, soit par voie chimique aqueuse, soit par gravure sèche, qui permettent de graver sélectivement le couple GalnP/GaAs. Ainsi, il est possible de graver entièrement une couche en GaInP et s'arrêter sur une couche en GaAs avec une sélectivité infinie.

Plus précisément, à partir d'une structure épitaxiée de transistor possédant toutes les couches fonctionnelles de matériaux semiconducteurs on peut réaliser la géométrie illustrée en figure 3.

Le transistor bipolaire à hétérojonction peut ainsi être élaboré à partir de la succession de couches suivantes illustrées en figure 4.

Sur un substrat S semi-isolant en GaAs, on réalise de façon classique
- une couche de sous-collecteur (SC), il s'agit typiquement de GaAs (Si) dopé n, de concentration 4.10¹⁸ cm⁻³ et d'épaisseur de l'ordre de 800 nm ;
- une couche de collecteur (C) en GaAs (Si) dopé n, de concentration 2.10¹⁶ cm⁻³ et d'épaisseur de l'ordre de 1000 nm ;
- une couche de base (B) en GaAs (carbone) dopé p, de concentration de l'ordre de 7.10¹⁹ cm⁻³ et d'épaisseur de l'ordre de 120 nm.

La structure émettrice sur laquelle porte l'invention ;
- une couche (1) en GalnP (Si) dopé n de concentration 3.10¹⁷ cm⁻³ de faible épaisseur, environ 30 nm ;
- une couche (2) en GaAs (Si) dopé n de concentration 3.10¹⁸ cm⁻³ de très faible épaisseur, environ 5 nm ;
- une couche (3) en GalnP (Si) dopé n de concentration 3.10¹⁷ cm⁻³ d'épaisseur de l'ordre de 120 nm.

De préférence, on intègre à la structure émettrice une couche de résistance de ballast, soit une couche (4) de concentration en dopage inférieur au dopage des couches (1) à (3), soit
- une couche (4) en GalnP (Si) dopé n de concentration de 7.10¹⁶ cm⁻³ d'épaisseur 250 nm.

On intègre également de manière classique :
- une couche (5) de GalnP (Si) fortement dopée n de concentration 3.10¹⁸ cm⁻³, d'environ 100 nm d'épaisseur. Cette couche sert de couche de transition entre l'émetteur majoritairement en GalnP et une couche supérieure en GaAs, facilitant la prise de contact ohmique d'émetteur ;
- une couche (6) en GaAs (Si) fortement dopée de concentration 3.10¹⁸ cm⁻³ d'épaisseur voisine de 200 nm ;
- une couche optionnelle (7) en Ga₁₋ₓInₓAs (Si) dopée 3:10¹⁸ cm⁻³ de 20 nm d'épaisseur sur laquelle est réalisée le contact émetteur CE.

A partir de l'empilement de toutes ces couches on réalise l'architecture souhaitée par gravure sélective du couple GaInP/GaAs. La dimension latérale du "mésa" comprenant la couche (3) est fixée par un procédé de gravure sèche telle que la gravure ionique réactive (RIE) qui utilise le contact ohmique d'émetteur comme masque de gravure ; les contacts d'émetteurs CE étant préalablement réalisés sur la couche supérieure (7). Les métallisations permettant la réalisation des contacts d'émetteur peuvent être un alliage en AuGe/Ni/Au.

Dans un second temps, l'ensemble peut être recouvert d'une résine positive, ultérieurement gravée où l'on souhaite délimiter le "mésa" inférieur correspondant aux couches (1) et (2). Dans les zones non recouvertes de résine, on grave les couches (1) et (2) jusqu'à la surface de la base.

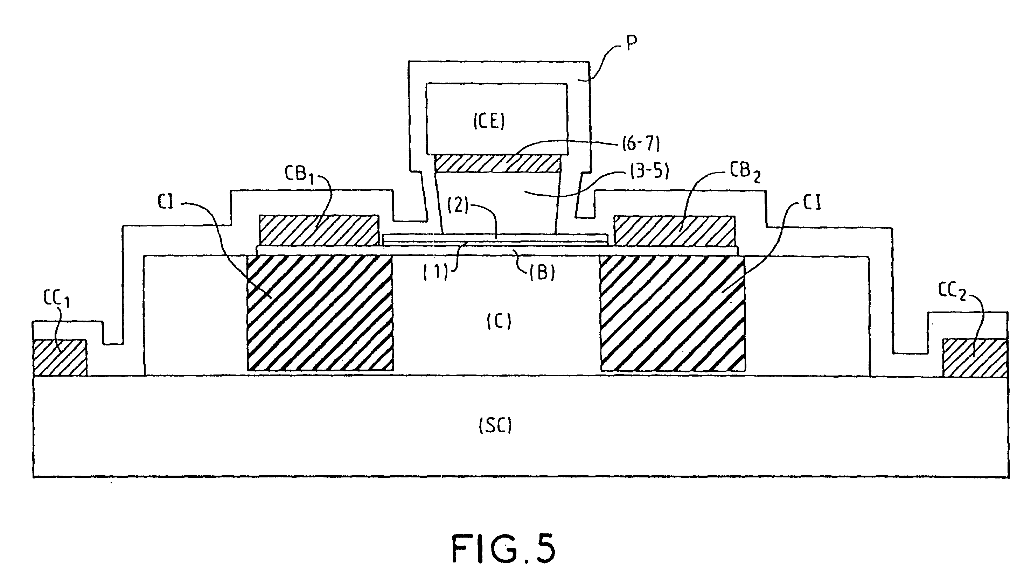

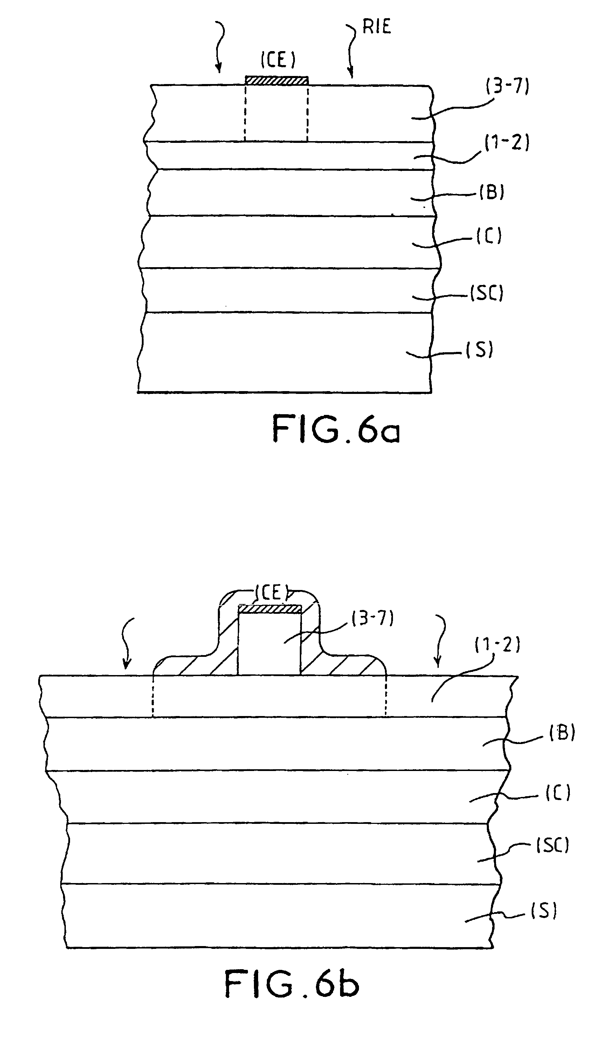

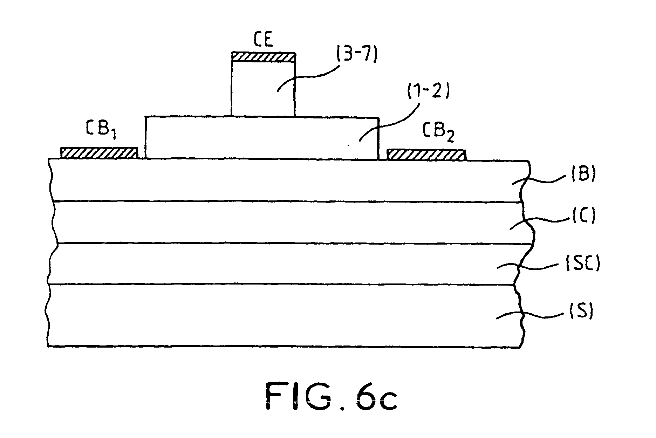

Par implantation ionique de Bore, on peut élaborer des caissons d'isolation électrique (Cl), de manière à limiter les capacités base-collecteur. Le bore diffuse en profondeur sous la couche de base, sur laquelle on peut définir ultérieurement par métallisation les contacts base CB₁ et CB₂ (illustrés en figure 5).

Le retrait de la résine sur les zones protégées conduit à l'obtention de la structure désirée.

L'ensemble est recouvert d'une couche de passivation protectrice (P).

## Revendications

1. Transistor bipolaire à hétérojonction à base de matériaux semiconducteurs du groupe III-V comprenant un substrat sur lequel sont respectivement superposés un collecteur, une base et un émetteur, présentant une structure en mésa constituée de matériaux semiconducteurs, **caractérisé en ce que** la structure en mésa de l'émetteur comprend superposées sur la base dans cette ordre une première couche (1) en matériau semiconducteur M_{I}, une seconde couche (2) en matériau semiconducteur M_{II}, et une troisième couche (3) en matériau semiconducteur M_{III}, les première et deuxième couches présentant une section plus grande que la section de la troisième couche, les sections des couches étant définies parallèlement au substrat, et les matériaux M_{II} et M_{III} possédant des comportements différents vis-à-vis de procédés de gravure, l'émetteur étant ainsi constitué des première, seconde et troisième couches au moins une couche (5) facilitant la prise de contact ohmique plus dopée que les couches constituant l'émetteur étant superposée à l'émetteur.

2. Transistor bipolaire à hétérojonction selon la revendication 1, **caractérisé en ce que** le matériau M_{I} est du GalnP et que le matériau M_{II} est du GaAs, le matériau M_{III} étant du GalnP.

3. Transistor bipolaire à hétérojonction selon l'une des revendications 1 à 2, **caractérisé en ce que** l'émetteur comprend également une couche (4) superposée à la couche (3), plus faiblement dopée que ladite couche (3), de manière à constituer une résistance de ballast intégrée au transistor.

4. Transistor bipolaire à hétérojonction selon l'une des revendications 1 à 3, **caractérisé en ce qu'**il comprend des caissons d'isolation électrique par implantation ionique au niveau du collecteur, de part et d'autre de la superposition collecteur, base, émetteur.

## Patentansprüche

1. Bipolartransistor mit Heteroübergang auf der Basis von Halbleitermaterialien der Gruppe III-V, mit einem Substrat, auf dem ein Kollektor, eine Basis bzw. ein Emitter angeordnet sind, die eine aus Halbleitermaterialien gebildete Mesa-Struktur aufweisen, **dadurch gekennzeichnet, daß** die Mesa-Struktur des Emitters in dieser Reihenfolge der Basis überlagert umfaßt: eine erste Schicht (1) aus einem Halbleitermaterial M_{I}, eine zweite Schicht (2) aus einem Halbleitermaterial M_{II} und eine dritte Schicht (3) aus einem Halbleitermaterial M_{III}, wobei die erste Schicht und die zweite Schicht einen größeren Querschnitt als die dritte Schicht aufweisen, wobei die Querschnitte der Schichten parallel zum Substrat definiert sind und wobei die Materialien M_{II} und M_{III} gegenüber Ätzverfahren ein jeweils unterschiedliches Verhalten zeigen, wobei der Emitter somit aus der ersten, der zweiten und der dritten Schicht gebildet ist und wobei dem Emitter wenigstens eine Schicht (5) überlagert ist, die die Herstellung eines ohmschen Kontakts erleichtert und stärker als die den Emitter bildenden Schichten dotiert ist.

2. Bipolartransistor mit Heteroübergang nach Anspruch 1, **dadurch gekennzeichnet, daß** das Material M_{I} GaInP ist und daß das Material M_{II} GaAs ist, wobei das Material M_{III} GaInP ist.

3. Bipolartransistor mit Heteroübergang nach einem der Ansprüche 1 bis 2, **dadurch gekennzeichnet, daß** der Emitter außerdem eine der Schicht (3) überlagerte Schicht (4) aufweist, die schwächer als die Schicht (3) dotiert ist, um so einen in den Transistor integrierten Ballastwiderstand zu bilden.

4. Bipolartransistor mit Heteroübergang nach einem der Ansprüche 1 bis 3, **dadurch gekennzeichnet, daß** er auf Höhe des Kollektors beiderseits der Überlagerung aus Kollektor, Basis und Emitter Gebiete zur elektrischen Isolation durch Ionenimplantation umfaßt.

## Claims

1. Heterojunction bipolar transistor based on group III-V semiconductor materials comprising a substrate on which there are respectively superposed a collector, a base and an emitter, having a mesa structure consisting of semiconductor materials, **characterized in that** the mesa structure of the emitter comprises, superposed on the base in the following order, a first layer (1) made of semiconductor material M_{I}, a second layer (2) made of a semiconductor material M_{II} and a third layer (3) made of semiconductor material M_{III}, the first and second layers having a greater cross section than the cross section of the third layer, the cross sections of the layers being defined parallel to the substrate, and the materials M_{II} and M_{III} exhibiting different types of behaviour with respect to etching processes, the emitter thus consisting of the first, second and third layers, at least one layer (5) facilitating the establishment of an ohmic contact more highly doped than the layers constituting the emitter, the said layer (5) being superposed on the emitter.

2. Heterojunction bipolar transistor according to Claim 1, **characterized in that** the material M_{I} is GaInP and **in that** the material M_{II} is GaAs, the material M_{III} being GaInP.

3. Heterojunction bipolar transistor according to either of Claims 1 and 3, **characterized in that** the emitter also includes a layer (4) superposed on the layer (3), more lightly doped that the said layer (3), so as to constitute a ballast resistor integrated into the transistor.

4. Heterojunction bipolar transistor according to any one of Claims 1 to 3, **characterized in that** it includes electrical isolating trenches formed by ion implantation at the collector, on each side of the collector, base, emitter superposition.
